(19) Europäisches Patentamt / European Patent Office / Office européen des brevets

(11) **EP 1 983 500 A2**

(12) **EUROPEAN PATENT APPLICATION**

(43) Date of publication:
**22.10.2008 Bulletin 2008/43**

(51) Int Cl.:
**G09G 3/20** (2006.01)  **G09G 3/36** (2006.01)
**G11C 19/28** (2006.01)

(21) Application number: **08103551.1**

(22) Date of filing: **15.04.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **16.04.2007 US 735619**

(71) Applicant: **TPO Displays Corp.**
**Miao-Li County (TW)**

(72) Inventors:
• **Tai, Ya-Hsiang**
**300, Hsinchu City (TW)**
• **Ku, Ksuan-Chun**
**500, Changhua City, Changhua County (TW)**

(74) Representative: **2K Patentanwälte Kewitz & Kollegen**
**Partnerschaft**
**Corneliusstrasse 18**
**60325 Frankfurt am Main (DE)**

(54) **Scan signal generator for matrix display**

(57) Systems for displaying images. The system comprises a scan signal detector (100A) with X+1 shift registers connected in series, generating X+1 output pulses (S1-Sn+1) in sequence according to a start pulse and a clock signal, and a logic unit (NG1-NG2n) coupled to the X+1 shift registers, generating Z scan signals (G1-G2n) in sequence according to the X+1 output pulses scan and Y enabling signals (ENB1,ENB2), wherein Y, X and Z are integers, Y > 1, X > 0 and Z≥X.

FIG. 2

## Description

## BACKGROUND OF THE INVENTION

### Field of the Invention

The invention relates to panel displays, and in particular to systems for displaying images.

### Description of the Related Art

Liquid crystal displays (LCDs) are used in a variety of applications including calculators, watches, color televisions, computer monitors, and many other electronic devices. Active matrix LCDs are a well known type of LCD. In a conventional active matrix LCD, each picture element (or pixel) comprises a thin film transistor (TFT) and one or more capacitors. The pixels are arranged and wired in an array having a plurality of rows and columns.

To address a particular pixel, the proper row is switched "on" (i.e., charged with a voltage), and a voltage is sent down the correct column. Since the other rows that a column intersects are turned off, only the TFT and capacitor at the particular pixel receive a charge. In response to the applied voltage, the liquid crystal within the cell of the pixel changes its rotation and tilt angle, and thus, the amount of light is absorbed or passing therethrough. This process then is repeated row by row. For example, a gate driver is required to scan the rows of pixels in sequence, and a data driver is required to provide data voltages to columns of pixels.

As resolution of AMLCD is increased, dot pitch in pixel array is decreased and more shift registers in gate driver are required to generate scan signals. In the conventional arrangement, however, the high resolution AMLCD suffers from the limited lateral layout area in the gate driver. Thus, when the resolution of the AMLCD is increased, layout difficulty in wire routing caused by shift registers increases accordingly.

## SUMMARY OF THE INVENTION

An embodiment of a system for displaying images, comprise a signal driving circuit with X+1 shift registers connected in series, generating X+1 output pulses in sequence according to a start pulse and a clock signal, and a logic unit coupled to the X+1 shift registers, generating Z driving signals in sequence according to the X+1 output pulses and Y enabling signals, wherein Y, X and Z are integers, $Y > 1$, $X > 0$ and $Z \geq X$.

The invention also provides another embodiment of system for displaying images, in which the system comprises N+1 shift registers generating N+1 output pulses in sequence according to a start pulse and a clock, and 2N logic gates generating driving signals according to the output pulses from the shift registers, and first and second enabling signals. For example, a first logic gate generates a first driving signal according to the first output pulse, the second output pulse and a first enabling signal, and a second logic gate generates a second driving signal according to the first output pulse, the second output pulse and the second enabling signal. A third logic gate generates a third driving signal according to the second output pulse, the third output pulse and the first enabling signal, and a fourth logic gate generates a fourth driving signal according to the second output pulse, the third output pulse and the second enabling signal, and so fourth.

The invention also provides a driving method for displaying images, in which first, second, third output pulses and so forth are generated in sequence according to a start pulse and a clock signal, a first driving signal is generated according to the first and the second output pulses and a first enabling signal, and a second driving signal is generated according to the first and the second output pulses and a second enabling signal. A third driving signal is generated according to the second and third output pulses and the first enabling signal, and a fourth driving signal is generated according to the second third output pulses and the second enabling signals, and so fourth, wherein the driving signals are generated in sequence.

## BRIEF DESCRIPTION OF THE DRAWINGS

The invention can be more fully understood by reading the subsequent detailed description and examples with references made to the accompanying drawings, wherein:

Fig. 1 is a diagram of a signal driving circuit;

Fig. 2 shows an embodiment of a signal driving circuit;

Fig. 3 is a timing chart of the signal driving circuit shown in Fig. 2;

Fig. 4 shows another embodiment of a signal driving circuit;

Fig. 5 is a timing chart of the signal driving circuit shown in Fig. 4;

Fig. 6 shows an embodiment of a display system;

Fig. 7 schematically shows an embodiment of an electronic device; and

Fig. 8 schematically shows an embodiment of an electronic device.

## DETAILED DESCRIPTION OF THE INVENTION

This description is made for the purpose of illustrating the general principles of the invention and should not be taken in a limiting sense. The scope of the invention is best determined by reference to the appended claims.

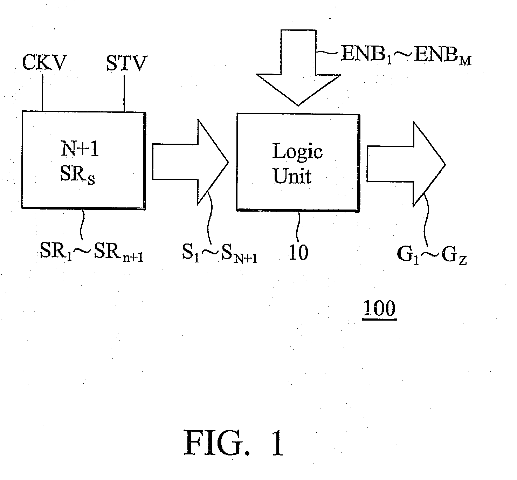

Fig. 1 is a diagram of a signal driving circuit. As shown, the signal driving circuit 100 can, for example, be a gate driver for providing driving signals $G_1 \sim G_Z$ to a display panel (not shown). The signal driving circuit 100 comprises N+1 shift registers $SR_1$~$SR_{n+1}$ connected in series, generating N+1 output pulses in sequence according to a start pulse STV and a clock signal CKV and a logic unit 10 generating the driving signals $G_1$~$G_Z$ in sequence according to the N+1 output pulses and M enabling signals, wherein M and N are positive integers, M > 1, N > 0, Z≥N, and Z=N x M. For example, the logic unit 10 comprises logic gates, such as AND gates, OR gates, XOR gates, NOR gates or combinations thereof.

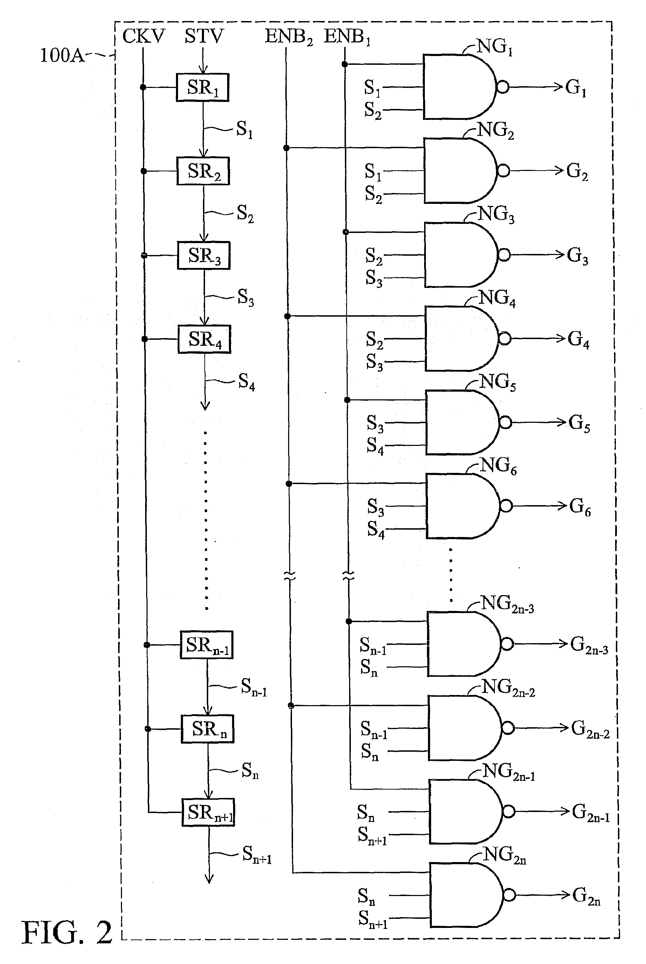

Fig. 2 shows an embodiment of a signal driving circuit. As shown, the signal driving circuit 100A comprises shift registers SR1~SRn+1 and NAND gates NG1~NG2n. The shift registers SR1~SRn+1 generate output pulses S1~Sn+1 in sequence according to the start pulse STV and the clock signal CKV. For example, the shift register SR1 generates an output pulse S 1 according to the start pulse STV and the clock signal CKV, the shift register SR2 generates an output pulse S2 according to the output pulse S 1 from the shift register SR1 and the clock signal CKV, the shift register SR3 generates an output pulse S3 according to the output pulse S2 from the shift register SR2 and the clock signal CKV, and so on.

The NAND gates NG1~NG2n generate driving signal to a display panel (not shown) according to the output pulses S1~Sn+1 and two enabling signals ENB1 and ENB2. For example, the NAND gate NG1 comprises three input terminals coupled to the output pulses S1 and S2 and the enabling signal ENB1 respectively, the NAND gate NG2 comprises three input terminals coupled to the output pulses S 1 and S2 and the enabling signal ENB2 respectively, the NAND gate NG3 comprises three input terminals coupled to the output pulses S2 and S3 and the enabling signal ENB 1 respectively, the NAND gate NG4 comprises three input terminals coupled to the output pulses S2 and S3 and the enabling signal ENB2 respectively, the NAND gate NG5 comprises three input terminals coupled to the output pulses S3 and S4 and the enabling signal ENB1 respectively, the NAND gate NG6 comprises three input terminals coupled to the output pulses S3 and S4 and the enabling signal ENB2 respectively, and so on.

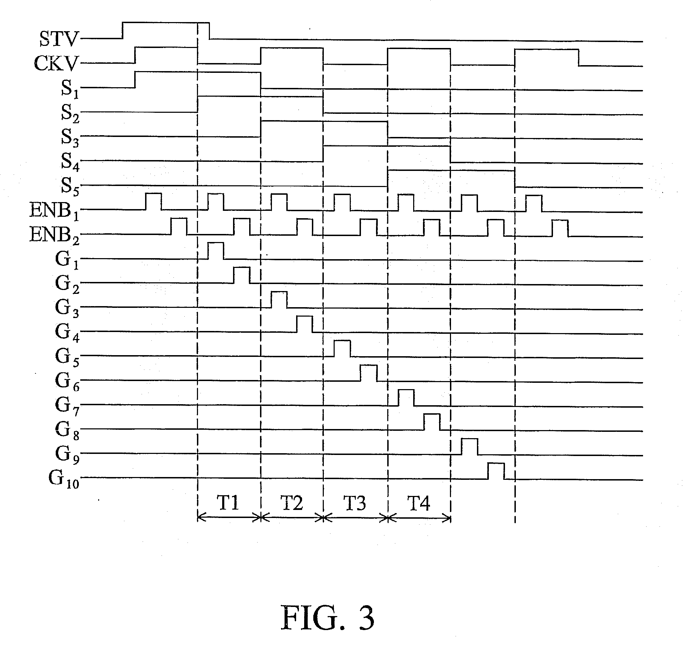

Fig. 3 is a timing chart of the signal driving circuit shown in Fig. 2. As shown, during period T1, the NAND gate NG1 generates the driving signal G1 when the output pulses S1 and S2 from the shift registers SR1 and SR2 and the enabling signal ENB1 go high. Similarly, the NAND gate NG2 generates the driving signal G2 when the output pulses S1 and S2 from the shift registers SR1 and SR2 and the enabling signal ENB2 go high, during period T1. Also, during period T2, the NAND gate NG3 generates the driving signal G3 when the output pulses S2 and S3 from the shift registers SR2 and SR3 and the enabling signal ENB1 go high, and the NAND gate NG4 generates the driving signal G4 when the output pulses S2 and S3 from the shift registers SR2 and SR3 and the enabling signal ENB2 go high.

During period T3, the NAND gate NG5 generates the driving signal G5 when the output pulses S3 and S4 from the shift registers SR3 and SR4 and the enabling signal ENB1 go high, and the NAND gate NG6 generates the driving signal G6 when the output pulses S3 and S4 from the shift registers SR3 and SR4 and the enabling signal ENB2 go high. During period T4, the NAND gate NG7 generates the driving signal G7 when the output pulses S4 and S5 from the shift registers SR4 and SR5 and the enabling signal ENB1 go high, and the NAND gate NG8 generates the driving signal G8 when the output pulses S4 and S5 from the shift registers SR4 and SR5 and the enabling signal ENB2 go high, and so on. Namely, the signal driving circuit 100A can generate 2n driving signals G1~G2n by n+1 shift registers and two enabling signals without 2n+1 shift registers.

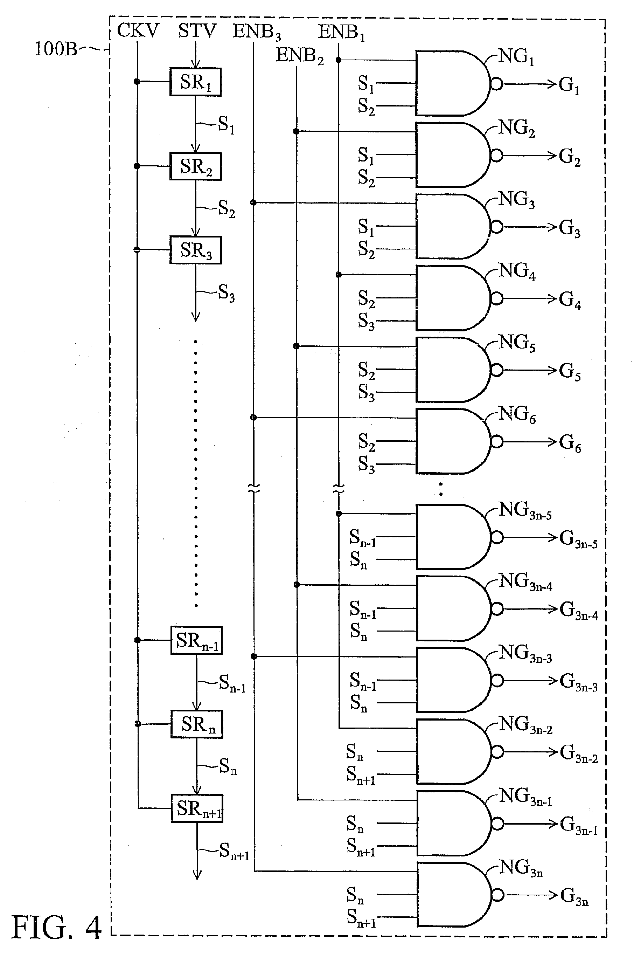

Fig. 4 shows another embodiment of a signal driving circuit. As shown, the signal driving circuit 100B comprises shift registers SR1~SRn+1 and NAND gates NG1~NG3n. The shift registers SR1~SRn+1 generate output pulses S1~Sn+1 in sequence according to the start pulse STV and the clock signal CKV. For example, the shift register SR1 generates an output pulse S1 according to the start pulse STV and the clock signal CKV, the shift register SR2 generates an output pulse S2 according to the output pulse S 1 from the shift register SR1 and the clock signal CKV, the shift register SR3 generates an output pulse S3 according to the output pulse S2 from the shift register SR2 and the clock signal CKV, and so on.

The NAND gates NG1~NG3n generate driving signals to a display panel (not shown) according to the output pulses S1~Sn+1 and three enabling signals ENB1~ENB3. For example, the NAND gate NG1 comprises three input terminals coupled to the output pulses S1 and S2 and the enabling signal ENB1 respectively, the NAND gate NG2 comprises three input terminals coupled to the output pulses S1 and S2 and the enabling signal ENB2 respectively, and the NAND gate NG3 comprises three input terminals coupled to the output pulses S1 and S2 and the enabling signal ENB3 respectively. The NAND gate NG4 comprises three input terminals coupled to the output pulses S2 and S3 and the enabling signal ENB1 respectively, the NAND gate NG5 comprises three input terminals coupled to the output pulses S2 and S3 and the enabling signal ENB2 respectively, the NAND gate NG6 comprises three input terminals coupled to the output pulses S2 and S3 and the enabling signal ENB3 respectively, and so on.

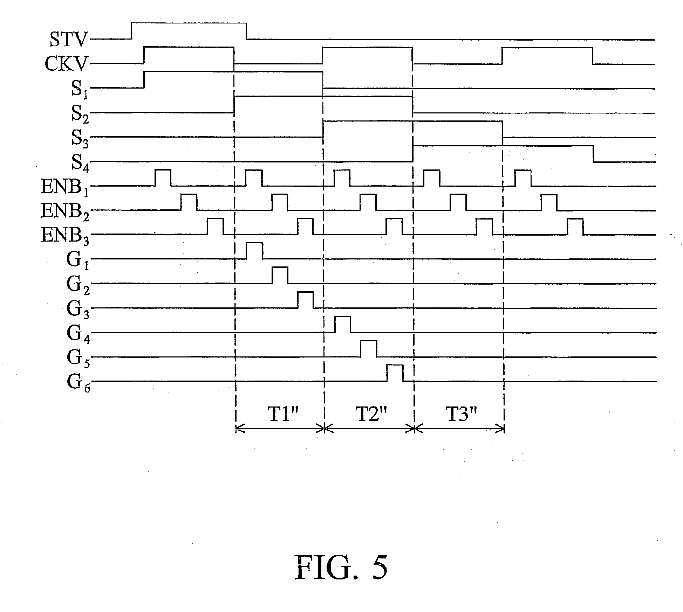

Fig. 5 is a timing chart of the signal driving circuit shown in Fig. 4. As shown, during period T1", the NAND gate NG1 generates the driving signal G1 when the output pulses S1 and S2 from the shift registers SR1 and SR2 and the enabling signal ENB1 go high. Similarly, the NAND gate NG2 generates the driving signal G2 when the output pulses S1 and S2 from the shift registers SR1 and SR2 and the enabling signal ENB2 go high, and the NAND gate NG3 generates the driving signal G3 when the output pulses S1 and S2 from the shift registers SR1 and SR2 and the enabling signal ENB3 go high.

During period T2", the NAND gate NG4 generates the driving signal G4 when the output pulses S2 and S3 from the shift registers SR2 and SR3 and the enabling signal ENB 1 go high, and the NAND gate NG5 generates the driving signal G5 when the output pulses S2 and S3 from the shift registers SR2 and SR3 and the enabling signal ENB2 go high. Similarly, the NAND gate NG6 generates the driving signal G6 when the output pulses S2 and S3 from the shift registers SR2 and SR3 and the enabling signal ENB3 go high, and so on. Namely, the signal driving circuit 100B can generate 3n driving signals G1~G3n by n+1 shift registers and three enabling signals without 3n+1 shift registers.

In the conversion gate driver, n+1 shift registers are required to generate n driving signals to driving scan lines in a display panel, 2n+1 shift registers are required to generate 2n driving signals, 3n+1 shift registers are required to generate 3n driving signals, and so on.

In the invention, because the signal driving circuit can generate 2n, 3n, 4n, 5n, ..., m x n driving signals with N+1 shift registers and m enabling signals, the number of shift registers in the signal driving circuit can be lower than in conventional signal driving circuits. Namely, as resolution of AMLCD is increased and dot pitch in pixel array is decreased, the invention generates more scan signals by more enabling signals and OR gates. Alternately, the invention can also be regarded as one shift register generating n driving signals by n enabling signals.

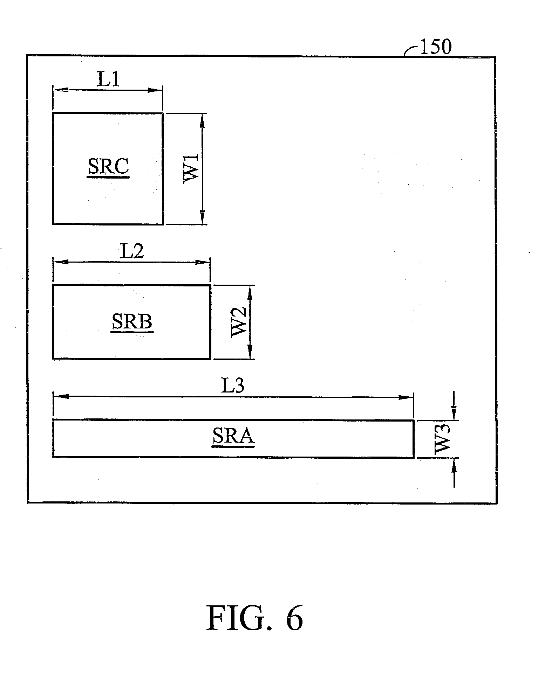

Fig. 6 shows different layouts of shift register with the same component. As shown, the shift register SRA has a length L3 of $865\mu m$ and a width W3 of $90\mu m$, the shift register SRB has a length L2 of $378\mu m$ and a width W2 of $180\mu m$, and the shift register SRC has a length L1 of $263\mu m$ and a width W1 of $270\mu m$, each generating a driving signal. In a fixed layout area in the substrate 150, conventional gate drivers generates n driving signals by n+1 shift registers SRAs. In the invention, the signal driving circuit 100A generates n driving signals by two enabling signals and $\dfrac{n+1}{2}$ shift registers SRB, and the signal driving circuit 100B generates n driving signals by three enabling signals and $\dfrac{n+1}{3}$ shift registers SRC. Thus, the number of shift registers and the lateral layout area in the signal driving circuit (gate driver) are reduced for high resolution AMLCD. Thus, layout difficulty in wire routing caused by shift registers can be alleviated. It should be noted that, if the frequency of the clock signal CKV in the convention signal driving circuit is F0, the frequency of the clock signal CKV for the shift registers is $\dfrac{1}{M}$ F0, in which M is the number of enabling signals of the logic unit 10. For example, the frequency of the clock signal CKV in the signal driving circuit 100A is $\dfrac{1}{2}$ F0, and the frequency of the clock signal CKV in the signal driving circuit 1008 is $\dfrac{1}{3}$ F0, and so on.

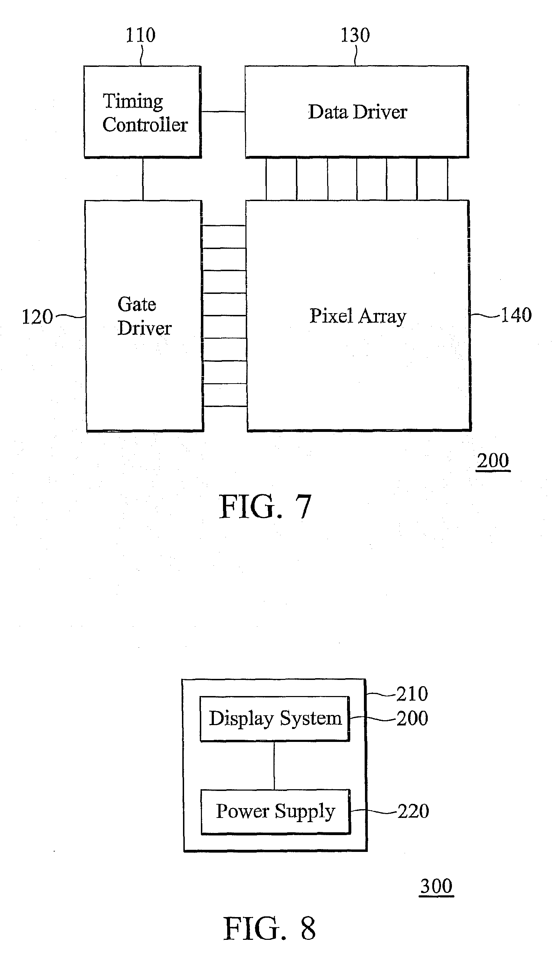

Fig. 7 shows an embodiment of a display system. As shown, the display system 200 comprises a timing controller 110, a gate driver 120, a data driver 130 and a pixel array 140. The timing controller 110 provides control signals to the gate driver 120 and the data driver 140, such that the gate driver 120 and the data driver 140 drive the pixel array to display images. For example, the timing controller 110 provides the start pulse STV and the clock signal CLV to the gate driver 120. The gate driver 120 can be implemented as the signal driving circuit 100/100A/100B to generate driving signals, driving the pixel array 140. The data driver 130 provides data voltages to the pixel array 140, such that the pixel array 140 displays images accordingly. For example, the pixel array 140 can be an organic light emitting pixel array, an electroluminescent pixel array or a liquid crystal pixel array but is not limited thereto.

Fig. 8 schematically shows an embodiment of an electronic device. In particular, electronic device 300 employs the display system 200 shown in Fig. 7. The electronic device 300 may be a device such as a PDA, digital camera, notebook computer, tablet computer, cellular phone or a display monitor device, for example. Generally, the electronic device 300 comprises a housing 210, a display system 200, and a power supply 220, although it is to be understood that various other components can be included, not shown or described here for ease of illustration and description. In operation, the power supply 220 powers the display system 200 to display color images.

While the invention has been described by way of example and in terms of preferred embodiment, it is to be understood that the invention is not limited thereto. To the contrary, it is intended to cover various modifications and similar arrangements (as would be apparent to those skilled in the art). Therefore, the scope of the appended claims should be accorded the broadest interpretation so as to encompass all such modifications and similar arrangements.

**Claims**

1.  A system for providing driving signals to a display element, comprising a signal driving circuit (100) comprising:

    X+1 shift registers ($SR_1$-$SR_{n+1}$) connected in se-

ries, generating X+1 output pulses in sequence according to a start pulse (STV) and a clock signal (CKV); and

a logic unit (10) coupled to the X+1 shift registers, generating Z driving signals ($G_1$ - $G_z$) in sequence according to the X+1 output pulses and Y enabling signals, wherein Y, X and Z are integers, $Y > 1$, $X > 0$ and $Z \geq X$.

2. The system as claimed in claim 1, wherein $Z = X \times Y$.

3. The system as claimed in claim 2, wherein the logic unit (10) comprises $X \times Y$ NAND gates (NG1 - NG2n) each comprising a first input terminal coupled to one of the Y enabling signals, a second input terminal, and a third input terminal coupled to two corresponding output pulses from the shift registers.

4. A system for displaying images, comprising a signal driving circuit comprising:

a first shift register (SR1) generating a first output pulse (S1) according to a start pulse (STV) and a clock signal (CKV);
a second shift register (SR2) generating a second output pulse (S2) according to the first output pulse (S1) and the clock signal (CKV);
a first logic gate (NG1) generating a first driving signal (G1) according to the first output pulse (S1), the second output pulse (S2) and a first enabling signal (ENB1); and
a second logic gate (NG2) generating a second driving signal (G2) according to the first output pulse (S1), the second output pulse (S2) and a second enabling signal (ENB2).

5. The system as claimed in claim 4, wherein the signal driving circuit further comprises:

a third shift register (SR3) generating a third output pulse (S3) according to the second output pulse (S2) and the clock signal (CKV);
a third logic gate (NG3) generating a third driving signal (G3) according to the second output pulse (S2), the third output pulse (S3) and the first enabling signal (ENB1); and
a fourth logic gate (NG4) generating a fourth driving signal (G4) according to the second output pulse (S2), the third output pulse (S3) and the second enabling signal (ENB2).

6. The system as claimed in claim 5, wherein the signal driving circuit further comprises:

a fourth shift register (Sr4) generating a fourth output pulse (S4) according to the third output pulse (S3) and the clock signal (CKV);
a fifth logic gate (NG5) generating a fifth driving signal (G5) according to the third output pulse (S3), the fourth output pulse (S4), and the first enabling signal (ENB1); and
a sixth logic gate (NG6) generating a sixth driving signal (G6) according to the third output pulse (S3), the fourth output pulse (S4), and the second enabling signal (ENB2).

7. The system as claimed in claim 6, wherein the first, the second, the third, the fourth, the fifth and the sixth logic gates comprise OR gates.

8. A driving method of a system for displaying images, comprising:

generating first, second and third output pulses in sequence according to a start pulse and a clock signal;
generating a first driving signal according to the first and the second output pulses and a first enabling signal; and
generating a second driving signal according to the first and the second output pulses and a second enabling signal, wherein the first and the second driving signals are generated in sequence.

9. The method as claimed in claim 8, further comprising:

generating a third driving signal according to the second and the third output pulses and the first enabling signal; and
generating a fourth driving signal according to the second and the third output pulses and the second enabling signal, wherein the first to the fourth driving signals are generated in sequence.

10. The method as claimed in claim 9, further comprising generating a third driving signal according to the first and the second output pulses and a third enabling signal, wherein the first to the third driving signals are generated in sequence.

CKV  STV       $\sim$ENB$_1 \sim$ENB$_M$

| N+1<br>SR$_s$ | | Logic<br>Unit | |

SR$_1 \sim$SR$_{n+1}$  S$_1 \sim$S$_{N+1}$  10    G$_1 \sim$G$_Z$

$\underline{100}$

# FIG. 1

FIG. 2

FIG. 3

FIG. 4

FIG. 5

FIG. 6

110　　　　　　　　　　130

| Timing Controller | Data Driver |

120 — | Gate Driver | Pixel Array | —140

200

FIG. 7

| Display System | ～210
～200 |
| Power Supply | ～220 |

300

FIG. 8